(19) Europäisches Patentamt / European Patent Office / Office européen des brevets

(11) **EP 1 879 292 B1**

(12) **EUROPEAN PATENT SPECIFICATION**

(45) Date of publication and mention
of the grant of the patent:
**06.03.2013 Bulletin 2013/10**

(51) Int Cl.:
*H03H 17/02* (2006.01)       *H04L 25/03* (2006.01)
*H04S 1/00* (2006.01)

(21) Application number: **06014253.6**

(22) Date of filing: **10.07.2006**

(54) **Partitioned fast convolution**

Partitionierte schnelle Faltung

Convolution rapide partitionée

(84) Designated Contracting States:
**AT BE BG CH CY CZ DE DK EE ES FI FR GB GR
HU IE IS IT LI LT LU LV MC NL PL PT RO SE SI
SK TR**

(43) Date of publication of application:
**16.01.2008 Bulletin 2008/03**

(73) Proprietor: **Harman Becker Automotive Systems
GmbH
76307 Karlsbad (DE)**

(72) Inventor: **Christoph, Markus
94315 Straubing (DE)**

(74) Representative: **Grünecker, Kinkeldey,
Stockmair & Schwanhäusser
Leopoldstrasse 4
80802 München (DE)**

(56) References cited:
**EP-A1- 0 531 242      WO-A-00/39926
WO-A-01/18960      WO-A-01/73947
WO-A-01/86808      WO-A1-94/01933
US-A- 5 999 574      US-A1- 2006 098 809**

EP 1 879 292 B1

Printed by Jouve, 75001 PARIS (FR)

**Description**

**Field of Invention**

The present invention relates to digital signal processing and, in particular, the filtering of audio signals by Finite Impulse Response filters (FIR). The invention particularly relates to filtering for echo compensation and equalization by means of long Finite Impulse Response filters.

**Background of the invention**

The enhancement of the quality of signals received in a communication system is a central topic in acoustic and, in particular, speech signal processing. The communication between two parties is often carried out in a noisy background environment and noise reduction as well as echo compensation are necessary to guarantee intelligibility. A prominent example is hands-free voice communication in vehicles.

Of particular importance is the handling of signals of the remote subscriber, which are emitted by the loudspeakers and therefore received again by the microphone(s), since otherwise unpleasant echoes can severely affect the quality and intelligibility of voice conversation. In the worst case acoustic feedback can even lead to a complete breakdown of communication.

To overcome the above mentioned problems means for acoustic echo compensation are provided, which basically works as follows. A replica of the acoustic feedback is synthesized and a compensation signal is obtained from the received signal of the loudspeakers. This compensation signal is subtracted from the sending signal of the microphone thereby generating a resulting signal to be sent to the remote subscriber. Furthermore, equalization of audio signals is usually necessary in order to enhance the quality of transmitted signals to an acceptable level, e.g., to increase the intelligibility of received speech signals that are sent by a remote communication party in hands-free telephony. The equalization filtering means usually processes the acoustic input signal by boosting or attenuating the signals over a pre-determined frequency range. The equalization filtering means may comprise a shelving filter for selectively boosting/ attenuating either the low or high frequency range and a peaking filter for boosting/attenuating signals with the center frequency, bandwidth in-band and out-band gains being separately adjustable. The equalization filtering means may further comprise a parametric equalizer that combines one or more shelving filters and peaking filters.

WO 01/86808 A discloses a digital filter comprising means for determining of a partial filter input initial condition, using a partitioned filter input signal, and partitioned filter input coefficients, means for determining a partial filter output initial condition, using a partitioned filter output signal, and partitioned filter output coefficients, and means for realizing said digital filter as a sum of outputs of FIR filter elements, wherein inputs of said FIR filter elements are dependent upon said partial filter input initial condition and said partial filter output initial condition, and said current block of filter input signal values.

WO 01/73947 A discloses an arbitrary sample rate conversion apparatus that includes a buffer for forming blocks of input samples having a first sample rate. For each block of input samples a subfilter is selected from a polyphase filter. Means are provided for block convolving each block of input samples with the corresponding selected subfilter for producing blocks of output samples having a second sample rate.

WO 01/18960 A discloses a digital convolution apparatus including means for determining a real-valued discrete-frequency representation of a desired digital filter and means for transforming said discrete-frequency representation into a corresponding discrete-time representation. Means circularly shift the discrete-time representation and means apply a window to the discrete-time representation to produce a zero-padded reduced length filter.

WO 94/01933 A discloses a digital filter with a long impulse response and lower latency, built by operating a number of small component filters in parallel and combining their outputs by addition, with each component filter operating with a different delay such that the net operation of the ensemble of said component filters is the same as a single filter with a longer impulse response, and the latency of the ensemble is equal to the shortest latency of the component filters. At least one group of the component filters is implemented using a Discrete Fourier Transform technique.

One main problem with currently available filtering means is the huge amount of filter coefficients to be adapted or to be optimized for an enhancement of the quality of the processed audio signal which results in very high memory requirements and a heavy processor load of the signal processing means. In the case of echo compensation filtering means, the sampling rate is therefore often limited to about 8 kHz which is considered marginally tolerable for speech signals.

For equalization filtering means Infinite Response (IIR) filters are usually employed, since implementation of Finite Impulse Response (FIR) filters has not been proven successful for the above mentioned reason. Equalizing has mainly to be performed in the high and mid frequency ranges and have to be realized with a relatively high accuracy for unreduced sampling rates of, e.g., about 44 kHz for acceptable results. Thus, very long filters comprising many filter coefficients become necessary. FIR filters, however, would be advantageous, since, e.g., they are unconditional stable filters (the filter output is not fed back) and easy to design.

To solve the above-mentioned problem it has been proposed to use short filters designed in a distorted frequency range, so-called warped FIR or IIR filters. However, warped filters also suffer from the need for a long computation time. According to an alternative approach, multirate digital systems or filter banks for dividing the audio signal that is to be processed in multiple frequency ranges by parallel band pass filters have been used for equalizing. However, this approach suffers from high memory requirements and a high latency, i.e. a long travel time of a signal from the input to the output of a filtering means.

Despite the recent developments and improvements, there is still a need for an improved filtering of digital signals by FIR filtering means. It is therefore the problem underlying the present invention to overcome the above-mentioned drawbacks and to provide a method for filtering digital signals and a long FIR filtering means with reduced requirements for computer resources and a reduced latency. Moreover, the FIR filtering means must be readily adoptable to a given kind of a digital signal processor.

**Description of the invention**

The above mentioned problems are solved by the herein disclosed method for processing a digital input signal by a Finite Impulse Response, FIR, filtering means, according to claim 1. The method comprises

Fourier transforming the digital input signal ($x[n]$) to obtain Fourier transformed signal partitions ($X_i(\omega)$);

partitioning the FIR filtering means in the time domain to obtain at least two partitions ($FIR_i[n]$) of the FIR filtering means;

Fourier transforming each of the at least two partitions ($FIR_i[n]$) of the FIR filtering means to obtain Fourier transformed filter partitions ($FIR_i(\omega)$);

performing a convolution of the Fourier transformed signal partitions ($X_i(\omega)$) and the corresponding Fourier transformed filter partitions ($FIR_i(\omega)$) to obtain spectral partitions ($Y_i(\omega)$);

combining the spectral partitions ($Y_i(\omega)$) to obtain a total spectrum ($Y(\omega)$); and

inverse Fourier transforming the total spectrum ($Y(w)$) to obtain a digital output signal $y([n])$:

wherein

the digital input signal ($x[n]$) is partitioned in the time domain by a partitioning delay line to obtain at least two partitions ($x_i[n]$) of the digital input signal; and

each of the at least two partitions ($x_i[n]$) of the digital input signal ($x[n]$) are Fourier transformed to obtain the Fourier transformed signal partitions $X_i(\omega)$.

The digital input signal can, e.g., be an audio signal or a speech signal. The disclosed method is particularly useful in the context of speech signal processing. Based on the Fourier transformations the convolution is performed in the frequency domain (which translates to the so-called circular convolution in the time domain). The digital input signal as well as the FIR filtering means are partitioned in the time domain and the resulting partitions are Fourier transformed for the convolution. Partitioning of the digital input signal can, in principle, be performed by filter banks comprising pass filters for particular frequency ranges (high pass, band pass and low pass filters). Preferably, the Fourier transformations are performed by means of Fast Fourier transformations resulting in a partitioned fast convolution.

It should be noted that whereas the disclosed method necessarily includes the Fourier transformation steps, the Fourier transforms are not necessarily calculated online in course of the filtering process. Rather, the FIR filter partitions can be Fourier transformed beforehand and can be stored in an external memory. This is particularly useful in the case of limited computer resources and a sufficiently large external memory. Storage of transformed filter partitions is also advantageous, if the FIR filtering means is not changed with time.

Partial or complete calculation of the Fourier transforms of filter partitions and storage of the Fourier transformed filter partitions beforehand may be carried according to the hardware resources that are available in a particular application.

The individual Fourier transformed signal partitions $X_1(\omega), .., X_p(\omega)$ corresponding to the signal partitions in the time domain are each multiplied by the respective Fourier transformed filter partitions $FIR_1(\omega), .., FIR_p(\omega)$ corresponding to the partitioned FIR filtering means. In principle, the number of the partitions of the audio signal $N_x$ and the number of the partitions of the FIR filtering means $N_{FIR}$ in the time domain can be different. In order to avoid circular artifacts the audio signal in the time domain and the filer partitions in the time domain can be padded with zeros prior to the Fourier transformation such that their respective lengths are $N_x + N_{FIR} - 1$.

It should be stressed that partitioning of the FIR filtering means is entirely carried out in the time domain. The partitions are convoluted in the spectral (frequency) domain. This mixed time - frequency processing allows for an implementation in an actual application under consideration of the advantages and disadvantages of the time and frequency processing, respectively.

It is well known that in contrast to a circular or fast convolution processing in the time regime, as in the case of a usual convolution process, is notoriously computationally expensive. On the other hand, signal processing in the frequency domain suffers from enormous memory requirements.

For given hardware resources the inventive method allows for an optimized usage of the available computer resources for the filtering of digital signals by long FIR filtering means by an appropriate choice of the chosen partition lengths. Filter lengths can be employed that would not be practicable in terms of the processor load and/or memory requirements by filtering methods of the art.

In addition, the latency of the signal processing according to the inventive method as well as the internal memory requirements and the processor load can be controlled by the length of the Fast Fourier transformation (FFT). The latency is given by twice the length of the employed FFT. The internal memory requirements increase proportional to the FFT length and is approximately four times the FFT length. The processor load increases with decreasing FFT lengths.

The digital input signal can advantageously be divided into blocks in the time domain and the convolution may be performed by means of an overlap-save block convolution. The digital input signal may be divided into blocks of equal size for a straightforward processing or, alternatively, into blocks of different sizes. Whereas shorter blocks provide a relatively low latency, longer blocks make the overall convolution less expensive in terms of processing power.

According to the overlap-save block convolution a long digital input signal is broken into successive blocks of $N_x$ samples, each block overlapping the previous block by $N_{FIR}$ samples. Circular convolution of each block is performed by the FIR filtering means. The first $N_{FIR} - 1$ points in each output block are discarded, and the remaining points are concatenated to create the output signal. Usually 50% of overlap will be used which is the maximally allowed size and corresponds to the critically sampled bank.

Instead of the overlap-save method the overlap-add method that represents a particularly simple block filtering method could be used. Uniform block sizes offer possibilities for performance optimization, if the overlap-add scheme is used in the frequency domain. The overlap-add method, however, is only practical, if the impulse response of the FIR filtering means is shorter than the block length $N_x$.

Moreover, the total spectrum obtained by a fast convolution can, in particular, be obtained by only using half of the number of the Fourier components of the Fourier transformed filter partitions. Efficient processing is, thus, enabled.

In a particularly efficient implementation of the herein disclosed method the Fourier transformed signal partitions and the Fourier transformed filter partitions are all of the same bandwidth and the mid frequencies are distributed on an equidistant discrete frequency raster. More complicated algorithms for the calculation of the distribution of the mid frequencies are possible and might be applied depending on the actual application.

It should be noted that alternatively to the above described embodiments of the inventive method a realization of the FIR filtering by means of decimation filter banks, in particular, critical decimation filter banks, in the time domain is possible.

The present invention also provides a computer program product, comprising one or more computer readable media having computer-executable instructions for performing the steps of an above-described example of the inventive method.

The above-mentioned problems are also solved by a signal processing means for processing a digital input signal, in particular, an audio signal or a speech signal, according to claim 10 comprising

a Fourier transforming means configured to Fast Fourier transform the digital input signal (x[n]);

an FIR filtering means partitioned in the time domain;

means for Fourier transforming the partitions ($FIR_i[n]$) of the FIR filtering means to obtain Fourier transformed filter partitions ($FIR_i(\omega)$);

wherein the FIR filtering means partitioned in the time domain is configured to filter the digital input signal (x[n]) by means of a fast convolution of the Fourier transformed signal partitions ($X_i(\omega)$) and the corresponding Fourier transformed filter partitions ($FIR_i(\omega)$) to obtain spectral partitions ($Y_i(\omega)$);

an adder configured to sum up the spectral partitions ($Y_i(\omega)$); and

an inverse Fast Fourier transforming means configured to inverse Fourier transform the added spectral partitions to obtain a digital output signal (y[n]) in the time domain;

a partitioning delay line configured to partition the digital input signal (x[n]) in the time domain

and wherein

the Fourier transforming means is configured to Fast Fourier transform each partition of the digital input signal (x[n]) separately to obtain Fourier transformed signal partitions ($X_i(\omega)$) by the fast convolution.

The FIR filtering means performs filtering of the digital input signal by convolving the Fourier transformed signal partitions and the corresponding Fourier transformed filter partitions of the same frequency range.

The signal processing means may further comprise a block dividing means configured to divide the digital input signal into blocks of equal or different sizes and the FIR filtering means may advantageously be configured to perform an overlap-save block convolution.

Since each partition can be retrieved separately from an external storage means, expensive internal memory can be saved. Since a plurality of FFTs is necessary in this case, computing time raises and also a fast interface to the external memory is necessary.

The above described examples of the inventive signal processing means can be advantageously used in equalization filtering means as well as echo compensation filtering means, if made adaptable. The equalization filtering means can, in particular, be applied to realize a static convolution with a long fixed FIR filter whith adjustable latency time.

The invention, moreover, provides a hands-free set and a speech recognition system and a speech dialog system each comprising one of the above mentioned examples of the signal processing means according to the present invention. A speech recognition system is a means for recognizing verbal utterances by analyzing the corresponding digitized speech signals. A speech dialog system includes a speech recognition system for processing a speech input and also includes a synthetic speech output means.

Additional features and advantages of the present invention will be described with reference to the drawings. In the description, reference is made to the accompanying figures that are meant to illustrate preferred embodiments of the invention. It is understood that such embodiments do not represent the full scope of the invention.

Figure 1 illustrates basic components of an example of the herein disclosed method for processing a digital input signal including partitioning of an FIR filtering means in time.

Figure 2 illustrates the processing of a digital input signal by an example of the partitioned fast convolution of a digital input signal according to the present invention.

Figure 3 illustrates the processing of a digital input signal by another example of the partitioned fast convolution of a digital input signal according to the present invention.

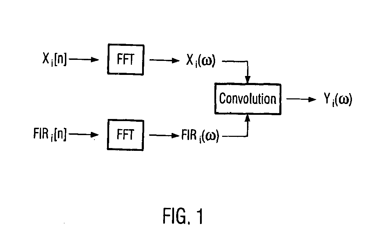

According to the present invention echo compensating or equalizing of audio signals can be performed by an FIR filtering means even when a huge number of filter coefficients must be employed in order to obtain an acoustic or speech signal of satisfying quality. The herein disclosed method comprises convolution of a digital input signal in the frequency domain. As shown in Figure 1 partitions of the input signal $x_i[n]$ indexed by integers i are subject to a Fast Fourier transformation FFT to obtain the Fourier transformed signal partitions $X_i(\omega)$ for predetermined frequency ranges.

It is a main aspect of the present invention that an FIR filter is entirely partitioned in the time domain to obtain filter partitions $FIR_i[n]$. According to the present example an equal number of filter partitions $FIR_i[n]$ and signal partitions $X_i(\omega)$ is chosen. Convolution by means of a long FIR filtering means can be carried out by a number of elementary fast convolutions with the respective filter partitions.

Independent of the number of the FIR filter coefficients the latency is determined by the length of the chosen FFT. In fact, the latency is given by twice the FFT length. In order to carry out the fast convolutions, the filter partitions $FIR_i[n]$ are Fast Fourier transformed to obtain Fourier transformed filter partitions $FIR_i(\omega)$:

$$FIR_i = \sum_{n=0}^{N_F-1} x[n]\exp\left(-\frac{2\pi i}{N_F}n\omega\right),$$

An FFT is an algorithm to compute the above sum in $O(N_F \log N_F)$ operations In practice, the FFT can be carried out, e.g., by means of the Cooley-Tukey algorithm.

The Fourier transformed signal partitions $X_i(\omega)$ are convoluted with the corresponding Fourier transformed filter partitions $FIR_i(\omega)$ to obtain results of the individual convolution processes $Y_i(\omega)$ as shown in Figure 1. The desired output signal $y[n]$ obtained as the result of the signal processing is subsequently achieved by summing up the signals $Y_i(\omega)$ and subsequently inverse Fast Fourier transforming the resulting total signal. The latency of the signal processing can be controlled by the length of the FFT, i.e. $N_F$. In symbolic notation the desired output signal is obtained by

$$y[n] = IFFT(Y(\omega)) \quad \text{with} \quad Y(\omega) = \sum_i Y_i(\omega) = \sum_i X_i(\omega) \cdot FIR_i(\omega),$$

where IFFT denotes the inverse Fast Fourier transformation.

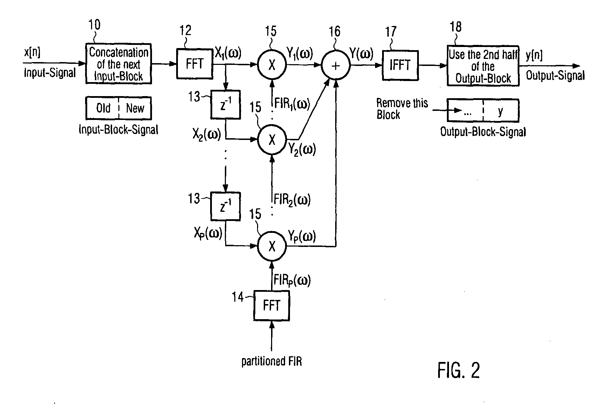

Figure 2 illustrates an example of the partitioned fast convolution method according to the present invention. The fast convolution is carried out for signal blocks by means of the overlap-save method. Details on the overlap-save FFT can be found, e.g., in Theory and applications of digital signal processing, Rabiner, L. and Gold, B., Englewood Cliffs, NJ, Prentice-Hall, 1975.

An input audio signal $x[n]$ is divided into blocks. Incoming blocks are sequentially concatenated 10 for processing. An incoming block is Fast Fourier transformed 12 to obtain Fourier transformed signal partitions $X_i(\omega)$. The individual Fourier transformed signal partitions $X_i(\omega)$, i = 1, .., p, represent the spectral representations of the respective signal partitions in the time domain and can thus be obtained by delay filtering 13 in the frequency regime.

The partitions of an FIR filtering means partitioned in the time domain are Fast Fourier transformed 14 to obtain Fourier transformed filter partitions $FIR_i(\omega)$, i = 1, .., p. Each Fourier transformed signal partitions $X_i(\omega)$ is convoluted by the corresponding Fourier transformed filter partition $FIR_i(\omega)$ 15 and the results $Y_i(\omega)$ are summed up 16 to obtain a total spectrum Y(w). According to the present example, the total spectrum Y(w) is the result of a fast convolution of the input signal block with half of the FFT length with the entire FIR filtering means that is partitioned in the time domain.

The output signal y[n] is obtained by means of an inverse Fast Fourier Transformation (IFFT) 17 of Y(w) and by keeping the second half of the output block 18 achieved by the IFFT.

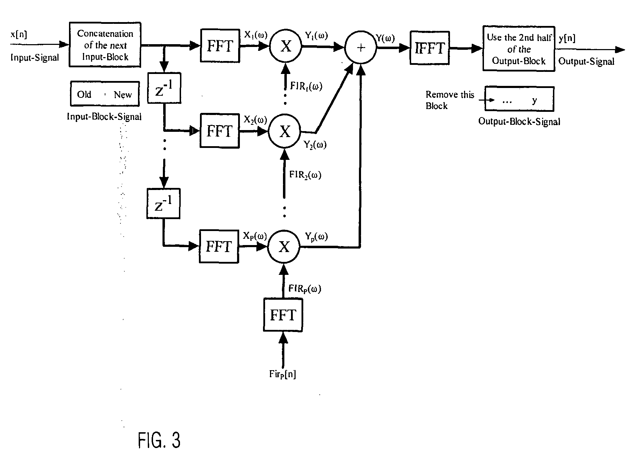

Figure 3 shows an alternative embodiment of the above described example of the partitioned fast convolution method according to the present invention. In this example, the partitioning of the digital input signal x[n] is not performed by the FFT filtering means itself but rather by a preceding partitioning delay line. Consequently, an FFT is performed for each of the partitions of the digital input signal x[n]. Further processing is performed as described above with reference to Figure 2.

Contrary to the example employing one single FFT of the digital input signal (see Figure 2) a plurality of FFTs is necessary. Consequently, the computing time raises and also a fast interface to the external memory is necessary. On the other hand, the costs for the internal memory can be reduced, since each partition is separately retrieved from an external memory and is subsequently loaded in the internal memory. Depending on the available hardware resources one might choose from the above mentioned two alternatives. This illustrates the flexibility of the partitioned fast convolution method of the present invention.

It is noted that the signal partitions may be Fourier transformed beforehand and the Fourier transformed signal partitions may be stored which is advantageous, if in a particular signal processing situation a relatively small number of input signals is to be convoluted with a relatively large number of FIR filters.

**Claims**

1. Method for processing a digital input signal (x[n]) by a Finite Impulse Response, FIR, filtering means, comprising
   Fourier transforming (12) the digital input signal (x[n]) to obtain Fourier transformed signal partitions ($X_i(\omega)$);
   partitioning the FIR filtering means in the time domain to obtain at least two partitions ($FIR_i[n]$) of the FIR filtering means;
   Fourier transforming (14) each of the at least two partitions ($FIR_i[n]$) of the FIR filtering means to obtain Fourier transformed filter partitions ($FIR_i(\omega)$);
   performing a convolution (15) of the Fourier transformed signal partitions ($X_i(\omega)$) and the corresponding Fourier transformed filter partitions ($FIR_i(\omega)$) to obtain spectral partitions ($Y_i(\omega)$);
   combining (16) the spectral partitions ($Y_i(\omega)$) to obtain a total spectrum ($Y(\omega)$); and
   inverse Fourier transforming (17) the total spectrum ($Y(\omega)$) to obtain a digital output signal y([n]);
   **characterized in that**
   the digital input signal (x[n]) is partitioned in the time domain by a partitioning delay line to obtain at least two partitions ($x_i[n]$) of the digital input signal; and each of the at least two partitions ($x_i[n]$) of the digital input signal (x[n]) are Fourier transformed (12) to obtain the Fourier transformed signal partitions $X_i(\omega)$.

2. The method according to claim 1, wherein the digital input signal (x[n]) is divided into blocks in the time domain and the convolution is performed by means of an overlap-save block convolution.

3. The method according to claim 2, wherein the digital input signal (x[n]) is divided into blocks of equal size.

4. The method according to claim 2, wherein the digital input signal (x[n]) is divided into blocks of different sizes.

5. The method according to one of the preceding claims, wherein the total spectrum (Y(w)) is obtained by using half of the number of the Fourier components of the Fourier transformed filter partitions.

6. The method according to one of the preceding claims, wherein the Fourier transformed signal partitions ($X_i(\omega)$) and the Fourier transformed filter partitions ($Y_i(\omega)$) are all of the same bandwidth and the mid frequencies are distributed on an equidistant discrete frequency raster.

7. The method according to one of the preceding claims, wherein Fourier transforming (12) each of the at least two partitions of the digital input signal and Fourier transforming (14) each of the at least two partitions of the FIR filtering are performed by Fast Fourier transformations.

8. The method according to one of the preceding claims, wherein the digital input signal (x[n]) is an audio signal or a speech signal.

9. Computer program product, comprising one or more computer readable media having computer-executable instructions for performing the steps of the method according to one of the claims 1 - 8.

10. Signal processing means for processing a digital input signal, in particular, an audio signal or a speech signal, comprising
a Fourier transforming means (12) configured to Fast Fourier transform the digital input signal (x[n]);
an FIR filtering means partitioned in the time domain
means for Fourier transforming the partitions ($FIR_i$[n]) of the FIR filtering means to obtain Fourier transformed filter partitions ($FIR_i(\omega)$);
wherein the FIR filtering means partitioned in the time domain is configured to filter the digital input signal (x[n]) by means of a fast convolution (15) of the Fourier transformed signal partitions ($X_i(\omega)$) and the corresponding Fourier transformed filter partitions ($FIR_i(\omega)$) to obtain spectral partitions ($Y_i(\omega)$);
an adder (16) configured to sum up the spectral partitions ($Y_i(\omega)$); and
an inverse Fast Fourier transforming means (17) configured to inverse Fourier transform the added spectral partitions to obtain a digital output signal (y[n]) in the time domain;
**characterized**
**by**
a partitioning delay line configured to partition the digital input signal (x[n]) in the time domain
and in that
the Fourier transforming means (12) is configured to Fast Fourier transform each partition of the digital input signal (x[n]) separately to obtain Fourier transformed signal partitions ($X_i((\omega)$) by the fast convolution.

11. Signal processing means according to claim 10, further comprising a block dividing means configured to divide the digital input signal into blocks of equal or different sizes and wherein the FIR filtering means is configured to perform an overlap-save block convolution.

12. Hands-free set comprising a signal processing means according to claim 10 or 11.

13. Speech recognition system or speech dialog system comprising a signal processing means according to claim 10 or 11.

**Patentansprüche**

1. Verfahren zur Verarbeitung eines digitalen Eingabesignals (x[n]) durch ein Mittel zum Filtern mit endlicher Impulsantwort, FIR, das Folgendes umfasst:

Fourier-Transformieren (12) des digitalen Eingabesignals (x[n]), um Fourier-transformierte Signalpartitionen ($X_i(\omega)$) zu erhalten;
Partitionieren des Mittels zum FIR-Filtern im Zeitbereich, um mindestens zwei Partitionen ($FIR_i$[n]) des Mittels zum FIR-Filtern zu erhalten;
Fourier-Transformieren (14) jeder der mindestens zwei Partitionen ($FIR_i$[n]) des Mittels zum FIR-Filtern, um Fourier-transformierte Filterpartitionen ($FIR_i(\omega)$) zu erhalten;
Durchführen einer Faltung (15) der Fourier-transformierten Signalpartitionen ($X_i(\omega)$) und der entsprechenden Fourier-transformierten Filterpartitionen ($FIR_i(\omega)$), um spektrale Partitionierungen ($Y_i(\omega)$) zu erhalten;
Kombinieren (16) der spektralen Partitionierungen ($Y_i(\omega)$), um ein Gesamtspektrum ($Y((\omega)$) zu erhalten, und
inverses Fourier-Transformieren (17) des Gesamtspektrums ($Y(\omega)$), um ein digitales Ausgabesignal zu erhalten;
**dadurch gekennzeichnet, dass**
das digitale Eingabesignal (x[n]) im Zeitbereich durch eine Partitionierungs-Verzögerungsleitung partitioniert wird, um mindestens zwei Partitionen ($x_i$[n]) des digitalen Eingabesignals zu erhalten, und wobei jede der mindestens zwei Partitionen ($x_i$[n]) des digitalen Eingabesignals (x[n]) Fourier-transformiert (12) wird, um die Fourier-transformierten Signalpartitionen $X_i(\omega)$ zu erhalten.

2. Verfahren nach Anspruch 1, wobei das digitale Eingabesignal (x[n]) im Zeitbereich in Blöcke unterteilt wird und die Faltung anhand einer Overlap-Save-Blockfaltung durchgeführt wird.

3. Verfahren nach Anspruch 2, wobei das digitale Eingabesignal (x[n]) in Blöcke gleicher Größe unterteilt wird.

4. Verfahren nach Anspruch 2, wobei das digitale Eingabesignal (x[n]) in Blöcke unterschiedlicher Größe unterteilt wird.

5. Verfahren nach einem der vorhergehenden Ansprüche, wobei das Gesamtspektrum $(Y(\omega))$ durch Verwenden der halben Anzahl der Fourier-Komponenten der Fourier-transformierten Filterpartitionen erhalten wird.

6. Verfahren nach einem der vorhergehenden Ansprüche, wobei die Fourier-transformierten Signalpartitionen $(X_i(\omega))$ und die Fourier-transformierten Filterpartitionen $(FIR_i(\omega))$ alle die gleiche Bandbreite haben und die mittleren Frequenzen auf einem äquidistanten diskreten Frequenzraster verteilt sind.

7. Verfahren nach einem der vorhergehenden Ansprüche, wobei das Fourier-Transformieren (12) jeder der mindestens zwei Partitionen des digitalen Eingabesignals und das Fourier-Transformieren (14) jeder der mindestens zwei Partitionen des FIR-Filterns mittels schneller Fourier-Transformationen durchgeführt werden.

8. Verfahren nach einem der vorhergehenden Ansprüche, wobei das digitale Eingabesignal (x[n]) ein Audiosignal oder ein Sprachsignal ist.

9. Computerprogrammprodukt, das einen oder mehrere computerlesbare Datenträger mit von einem Computer ausführbaren Anweisungen zum Durchführen der Schritte des Verfahrens nach einem der Ansprüche 1-8 umfasst.

10. Mittel zur Signalverarbeitung zur Verarbeitung eines digitalen Eingabesignals, insbesondere eines Audiosignals oder eines Sprachsignals, das Folgendes umfasst:

   ein Fourier-transformierendes Mittel (12), das so konfiguriert ist, dass eine schnelle Fourier-Trasformation des digitalen Eingabesignals (x[n]) durchgeführt wird;
   ein Mittel zum FIR-Filtern, das im Zeitbereich partitioniert ist;
   Mittel zum Fourier-Transformieren der Partitionen $(FIR_i[n])$ des Mittels zum FIR-Filtern, um Fourier-transformierte Filterpartitionen $(FIR_i(\omega))$ zu erhalten;
   wobei das Mittel zum FIR-Filtern, das im Zeitbereich partioniert wird, so konfiguriert ist, dass es das digitale Eingabesignal (x[n]) anhand einer schnellen Faltung (15) der Fourier-transformierten Signalpartitionen $(X_i(\omega))$ und der entsprechenden Fourier-transformierten Filterpartitionen $(FIR_i(\omega))$ filtert, um spektrale Partitionierungen $(Y_i(\omega))$ zu erhalten;
   ein Addierer (16), der so konfiguriert ist, dass er die spektralen Partitionierungen $(Y_i(\omega))$ aufaddiert, und
   ein Mittel zur inversen schnellen Fourier-Transformation (17), das so konfiguriert ist, dass es die aufaddierten spektralen Partitionierungen invers Fourier-transformiert, um ein digitales Ausgabesignal (y[n]) im Zeitbereich zu erhalten;
   **gekennzeichnet**
   **durch**
   eine Partitionierungs-Verzögerungsleitung, die dazu konfiguriert ist, das digitale Eingabesignal (x[n]) im Zeitbereich zu partitionieren
   und **dadurch**, dass
   das Mittel zum Fourier-Transformieren (12) so konfiguriert ist, dass es jede Partition des digitalen Eingabesignals (x[n]) getrennt schnell Fourier-transformiert, um durch die schnelle Faltung Fourier-transformierte Signalpartitionen $(X_1(\omega))$ zu erhalten.

11. Mittel zur Signalverarbeitung nach Anspruch 10, das weiterhin ein in Blöcke teilendes Mittel umfasst, das so konfiguriert ist, dass es das digitale Eingabesignal in Blöcke gleicher oder unterschiedlicher Größe teilt, und worin das Mittel zum FIR-Filtern so konfiguriert ist, dass es eine Overlap-Save-Blockfaltung durchführt.

12. Freisprechanlage, die ein Mittel zur Signalverarbeitung nach Anspruch 10 oder 11 umfasst.

13. Spracherkennungssystem oder Sprachdialogsystem, das ein Mittel zur Signalverarbeitung nach Anspruch 10 oder 11 umfasst.

**Revendications**

1. Procédé de traitement d'un signal numérique d'entrée (x[n]) par un moyen de filtrage de type réponse impulsionnelle finie, RIF, consistant à

   appliquer la transformée de Fourier (12) au signal numérique d'entrée (x[n]) afin d'obtenir des partitions de signaux selon la transformée de Fourier ($X_i(\omega)$) ;
   partitionner un moyen de filtrage RIF dans le domaine temporel pour obtenir au moins deux partitions ($RIF_i[n]$) du moyen de filtrage RIF ;
   appliquer la transformée de Fourier (14) à chacune des au moins deux partitions ($RIF_i[n]$) du moyen de filtrage RIF pour obtenir des partitions de filtres selon la transformée de Fourier ($RIF_i(\omega)$));
   effectuer une convolution (15) des partitions de signaux selon la transformée de Fourier ($X_i(\omega)$) et des partitions correspondantes de filtres selon la transformée de Fourier ($RIF_i(\omega)$) pour obtenir des partitions spectrales ($Y_i(\omega)$) ;
   combiner (16) les partitions spectrales ($Y_i(\omega)$) pour obtenir un spectre global ($Y(\omega)$) ; et
   appliquer la transformée de Fourier inverse (17) au spectre total ($Y(\omega)$) pour obtenir un signal numérique de sortie y([n]) ;
   **caractérisé en ce que**
   le signal numérique d'entrée (x(n)) est partitionné dans le domaine temporel par une ligne de retard de partitionnement pour obtenir au moins deux partitions ($x_i(n)$) du signal d'entrée numérique ; et
   chacune des au moins deux partitions ($x_i[n]$) du signal d'entrée numérique (x[n]) sont soumises à la transformée de Fourier (12) pour obtenir les partitions de signaux selon la transformée de Fourier ($X_i(\omega)$).

2. Procédé selon la revendication 1, dans lequel le signal numérique d'entrée (x[n]) est divisé en blocs dans le domaine temporel et la convolution est effectuée par une convolution en bloc de type chevauchement/sauvegarde.

3. Procédé selon la revendication 2, dans lequel le signal numérique d'entrée (x[n]) est divisé en blocs de taille égale.

4. Procédé selon la revendication 2, dans lequel le signal numérique d'entrée (x[n]) est divisé en blocs de tailles différentes.

5. Procédé selon l'une quelconque des revendications précédentes, dans lequel le spectre total ($Y(\omega)$) s'obtient en utilisant la moitié du nombre des composantes de Fourier des partitions de filtres selon la transformée de Fourier.

6. Procédé selon l'une quelconque des revendications précédentes, dans lequel les partitions de signaux selon la transformée de Fourier ($X_i(\omega)$) et les partitions de filtres selon la transformée de Fourier ($RIF_i(\omega)$) ont toutes la même largeur de bande et les fréquences moyennes sont réparties sur un grille de fréquences discrètes équidistantes.

7. Procédé selon l'une quelconque des revendications précédentes, dans lequel la transformée de Fourier (12) utilisée pour chacune des au moins deux partitions du signal d'entrée numérique et la transformée de Fourier (14) utilisée pour chacune des au moins deux partitions de filtrage RIF sont des transformées de Fourier rapides.

8. Procédé selon l'une quelconque des revendications précédentes, dans lequel le signal numérique d'entrée (x[n]) est un signal audio ou un signal de parole.

9. Produit de programme informatique, comprenant un ou plusieurs supports lisibles par ordinateur comportant des instructions exécutables par ordinateur pour exécuter les étapes du procédé selon l'une quelconque des revendications de 1 à 8.

10. Moyen de traitement de signaux pour traiter un signal numérique d'entrée, en particulier, un signal audio ou un signal de parole, comprenant un moyen d'application de la transformée de Fourier (12) configuré pour appliquer la transformée de Fourier rapide au signal numérique d'entrée (x[n]) ;
    un moyen de filtrage RIF partitionné dans le domaine temporel ;
    un moyen d'application de la transformée de Fourier aux partitions ($RIF_i[n]$) du moyen de filtrage RIF pour obtenir des partitions de filtres selon la transformée de Fourier ($RIF_i(\omega)$) ;
    dans lequel le moyen de filtrage RIF partitionné dans le domaine temporel est configuré pour filtrer le signal numérique d'entrée (x[n]) au moyen d'une convolution rapide (15) des partitions de signaux selon la transformée de Fourier ($X_i(\omega)$) et des partitions correspondantes de filtres selon la transformée de Fourier ($RIF_i(\omega)$) pour obtenir des partitions spectrales ($Y_i(\omega)$) ;
    un additionneur (16) configuré pour additionner les partitions spectrales ($Y_i(\omega)$) ; et

un moyen d'application de la transformée de Fourier rapide inverse (17) configuré de manière à appliquer la transformée de Fourier inverse aux partitions spectrales ajoutées pour obtenir un signal de sortie numérique (y[n]) dans le domaine temporel;

**caractérisé par**

une ligne de retard de partitionnement configurée pour partitionner le signal numérique d'entrée (x[n]) dans le domaine temporel

et en ce que

le moyen d'application de la transformée de Fourier (12) est configuré pour appliquer séparément la transformée de Fourier rapide à chaque partition du signal numérique d'entrée (x[n]) afin d'obtenir des partitions de signaux selon la transformée de Fourier ($X_i(\omega)$) par convolution rapide.

11. Moyen de traitement de signaux selon la revendication 10, comprenant en outre un moyen de division de blocs configuré pour diviser le signal numérique d'entrée en blocs de tailles égales ou différentes, et dans lequel le moyen de filtrage RIF est configuré pour effectuer une convolution en bloc de type chevauchement/sauvegarde.

12. Ensemble mains-libres comprenant un moyen de traitement de signaux selon les revendications 10 ou 11.

13. Système de reconnaissance de la parole ou système de dialogue vocal comprenant un moyen de traitement de signaux selon les revendications 10 ou 11.

FIG. 1

FIG. 2

x[n]
Input-Signal

Concatenation
of the next
Input-Block

FFT
$X_1(\omega)$
X
$Y_1(\omega)$
+
$Y(\omega)$
IFFT
Use the 2nd half
of the
Output-Block
y[n]
Output-Signal

$FIR_1(\omega)$

Old | New

Input-Block-Signal

$z^{-1}$

FFT
$X_2(\omega)$
X
$Y_2(\omega)$

$FIR_2(\omega)$

Remove this
Block
... y

Output-Block-Signal

$z^{-1}$

FFT
$X_P(\omega)$
X
$Y_P(\omega)$

$FIR_P(\omega)$

FFT

$Fir_P[n]$

FIG. 3

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 0186808 A
- WO 0173947 A
- WO 0118960 A
- WO 9401933 A

**Non-patent literature cited in the description**

- **RABINER, L. ; GOLD, B. ; ENGLEWOOD CLIFFS, NJ.** Theory and applications of digital signal processing. Prentice-Hall, 1975